# EUROPÄISCHE PATENTSCHRIFT

(11) **EP 1 502 299 B1**
(45) Veröffentlichungstag und Bekanntmachung des Hinweises auf die Patenterteilung: **17.10.2007**
(21) Anmeldenummer: 03722370.8
(22) Anmeldetag: 31.03.2003
(51) Int. Cl.: H01L 21/768, C23C 18/16, H01L 23/532, H01L 51/30, H01L 21/288, H01L 21/48, H01L 51/00

(54) **KONTAKTIERUNG VON NANORÖHREN**
CONTACTING OF NANOTUBES
ETABLISSEMENT DES CONTACTS DE NANOTUBES

(30) Priorität: 06.05.2002 DE 10220194
(43) Veröffentlichungstag der Anmeldung: 02.02.2005
(73) Patentinhaber: Qimonda AG, 81739 München (DE)
(72) Erfinder: DÜSBERG, Georg, Stefan, 81541 München (DE); GRAHAM, Andrew, 81547 München (DE); KREUPL, Franz-Martin, 80802 München (DE); LIEBAU, Maik, 81735 München (DE); UNGER, Eugen, 86161 Augsburg (DE)
(74) Vertreter: Müller-Boré & Partner Patentanwälte
(86) Internationale Anmeldenummer: PCT/EP2003/003341
(87) Internationale Veröffentlichungsnummer: WO 2003/094226

(56) Entgegenhaltungen:
- EP-A- 1 198 001
- WO-A-01/44796
- TANS S J ET AL: "INDIVIDUAL SINGLE-WALL CARBON NANOTUBES AS QUANTUM WIRES" NATURE, Bd. 386, 1997, Seiten 474-477, XP000887119
- DATABASE INSPEC [Online] INSTITUTE OF ELECTRICAL ENGINEERS, STEVENAGE, GB; DUNSCH L ET AL: "Electrochemical metal deposition on carbon nanotubes" Database accession no. 7179911 XP002280383 & NEW DIAMOND AND FRONTIER CARBON TECHNOLOGY, 2001, MYU, JAPAN, Bd. 11, Nr. 6, Seiten 427-435, ISSN: 1344-9931
- JEONG-O LEE ET AL: "Formation of low-resistance ohmic contacts between carbon nanotube and metal electrodes by a rapid thermal annealing method" JOURNAL OF PHYSICS D (APPLIED PHYSICS), 21 AUG. 2000, IOP PUBLISHING, UK, Bd. 33, Nr. 16, Seiten 1953-1956, XP002279404 ISSN: 0022-3727
- AUSTIN D W ET AL: "The electrodeposition of metal at metal/carbon nanotube junctions" CHEMICAL PHYSICS LETTERS, 6 AUG. 2002, ELSEVIER, NETHERLANDS, Bd. 361, Nr. 5-6, Seiten 525-529, XP002279405 ISSN: 0009-2614

## Beschreibung

Die vorliegende Erfindung betrifft ein Verfahren zur Kontaktierung von Nanoröhren, insbesondere Kohlenstoff-Nanoröhren, im Rahmen deren Integration in einer elektrischen Schaltung, worin die Nanoröhren nach dem Aufbringen auf die metallischen Leiterbahnen der elektrischen Schaltung an den Kontaktstellen mit diesen durch stromloses Metallisieren verbunden werden.

Infolge der Eignung von Nanoröhren, insbesondere Kohlenstoff-Nanoröhren, als metallische Leiter sowie als Halbleiter ist es im Rahmen der Nanoschaltungstechnik wünschenswert, solche Nanoröhren auf elektrische Schaltungen bzw. elektronische Bauteile fest aufzubringen. Die Anwendung von Nanoröhren als Bauelemente, z.B. in elektrischen Schaltungen, setzt dabei deren Kontaktierung mit metallischen Leitern voraus. Zur Verfügung stehen derartige Nanoröhren üblicherweise als Dispersionen, als Folie bzw. bucky paper oder als Pulver. Bei Auftragung solcher Dispersionen auf elektrische Schaltungen werden üblicherweise zufällige bzw. statistische Verteilungen von Bündeln und isolierten Nanoröhren erhalten, die durch van der Waalsche Kräfte auf einer mit elektrischen Leitern versehenen Oberfläche des elektronischen Bauteils gehalten werden.

Für den Einsatz von Nanoröhren als Leiter bzw. als aktive Bauelemente müssen diese in einer elektrischen Schaltung mit den Leiterbahnen derart kontaktiert bzw. verbunden werden, daß dem Strom an den Kontaktstellen ein möglichst geringer Widerstand entgegengesetzt wird. Ferner ist es erforderlich, daß die Nanoröhren an den Kontaktstellen ausreichend mechanisch verankert bzw. fixiert sind. Ohne jegliche Behandlung der Nanoröhre/Leiterbahn-Kontaktstellen, d.h. wenn die Nanoröhren lediglich über van der Waalsche Kräfte auf der Leiterbahn gehalten werden bzw. abgelegt sind, werden jedoch Kontaktwiderstände von einigen hundert Kiloohm (kΩ) bis zu Megaohm (MΩ) beobachtet, was die Verwendung solcher Nanoröhren in elektrischen Schaltungen erheblich erschwert.

Das Erreichen niederohmiger Kontakte zwischen Nanoröhren und Leiterbahnen war bisher nur in Einzelfällen unter erheblichem Aufwand möglich. So beschreibt beispielsweise Bachtold et al., Applied Physics Letters, Bd. 73, Nr. 2, 1998, Seiten 274 bis 276, das "Löten" von Kohlenstoff-Nanoröhren an Goldkontakte mittels eines Elektronenstrahls, wodurch Kohlenstoff aus dem Restgas wie in einer Art "Brennfleck" an der Kontaktstelle abgeschieden wird. Weiter ist es möglich, Metall unter Verwendung einer "focused ion beam"-Anlage an den Kontaktstellen abzuscheiden. So wird in Wei et al., Applied Physics Letters, Bd. 74, Nr. 21, 1999, Seiten 3149 bis 3151, das Abscheiden von Wolfram an den Kontaktstellen mittels einer solchen "focused ion beam"-Anlage bei Verwendung von W(CO)₆ als Wolframquelle beschrieben. Ferner kann in einem photolithographischen Schritt über der Schaltung eine Resistschicht derart strukturiert werden, daß über den Kontaktstellen Öffnungen gebildet werden, durch die Metall, beispielsweise Titan, im Vakuum aufgebracht wird. Nach einem Lift-off-Schritt verbleibt das Metall nur an den Kontaktstellen; vgl. Zhang et al., Chemical Physics Letters, 331 (2000), Seiten 35 bis 41. Im allgemeinen folgt auf diese Prozesse noch eine Temperaturbehandlung zur Verbesserung der Kontaktstellen. Die vorstehenden Verfahren sind jedoch äußerst aufwändig. Darüberhinaus ist mit diesen Verfahren die Fixierung ganzer Nanoröhren-Bündel oder Arrays von Nanoröhren nach deren Wachstum nicht bzw. kaum möglich.

In Nature, Vol. 368, Seiten 474-477, 1997 werden Einzelwand-Kohlenstoffnanoröhren als Quantendrähte und deren Herstellung mittels Laserverdampfungbeschrieben, wobei die einzelne Röhre unter Bildung eines entsprechenden Schaltkreises mit zwei Elektroden kontaktiert wird.

In New Diamond and Frontier Carbon Technology, 2001, MYV, JAPAN, Bd. 11, Nr.b, Seiten 427-435 wird Elektroabscheidung von Kupfer auf mehrwändigen Kohlenstoffnanoröhren, immobilisiert auf einer Elektrodenoberflächebeschreiben, als Modell zur Metallabscheidung auf diesen Kohlenstoffnanostrukturen. In diesem Zusammenhang wird das elektrochemische Verhalten von mehrwändigen Kohlenstoffnanoröhren bezüglich der Metallabscheidung mit Cyclovoltammetrie in Schwefelsäurelösungen bestimmt.

Das Dokument EP-A-1198001 beschreibt im Zusammenhang mit der Herstellung von entsprechenden Halbleitervorrichtungen die Abschiedung von Beschichtungen mit kontrollierter Dicke durch Plattieren von drahtförmigen Anschlusselementen (Bonddrähte als auch elektrish nicht leitende drahtförmige Strukturen wie Kohlefasern) und den damit verbundenen Anschlussflächen.

Der vorliegenden Erfindung liegt somit die Aufgabe zugrunde, ein Verfahren zum Kontaktieren von Nanoröhren, insbesondere Kohlenstoff-Nanoröhren, im Rahmen deren Integration in einer elektrischen Schaltung bereitzustellen, das einerseits einen möglichst niederohmigen Kontakt zwischen Nanoröhre und Leiterbahn und andererseits gleichzeitig einen mechanisch festen Kontakt zwischen Nanoröhre und Leiterbahn liefern soll. Ein derartiges Verfahren soll dabei einfach und möglichst hochparallel durchführbar sein.

Diese Aufgabe wird durch die in den Ansprüchen gekennzeichneten Ausführungsformen gelöst.

Insbesondere wird ein Verfahren zur Kontaktierung von Nanoröhren im Rahmen deren Integration in einer elektrischen Schaltung bereitgestellt, umfassend die Schritte:
(a) Aufbringen einer vorbestimmten, mindestens zwei Leiterbahnen umfassenden Leiterbahnanordnung auf ein Substrat,
(b) Aufbringen von mindestens einer Nanoröhre auf das in Schritt (a) derart strukturierte Substrat und
(c) Unterwerfen der in Schritt (b) erhaltenen Anordnung einer stromlosen Metallisierung in einem Badverfahren unter Anwendung eines wässrigen, Metallkationen-enthaltenden Elektrolyten dergestalt, daß Metall auf der Leiterbahnanordnung unter mindestens teilweisem Einschluß der mindestens einen Nanoröhre an deren Kontaktstellen mit den Leiterbahnen abgeschieden wird.

Gemäß dem Verfahren der vorliegenden Erfindung wird Metall in einem einfachen Badverfahren auf entsprechend vorbereiteten Kontaktflächen bzw. Leiterbahnen einer vorgesehenen Mikroschaltung zum Zwecke der Kontaktierung von Nanoröhren stromlos abgeschieden. Das erfindungsgemäße Verfahren benötigt zur Kontaktierung der Nanoröhren in besonders vorteilhafter Weise keine aufwändigen Vakuumanlagen.

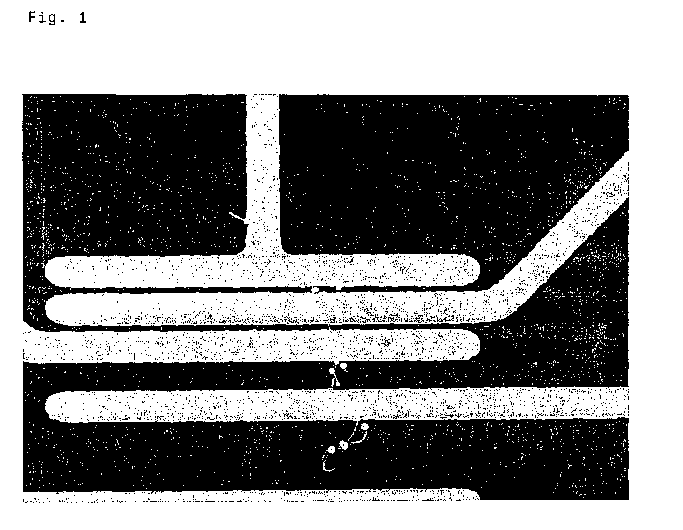

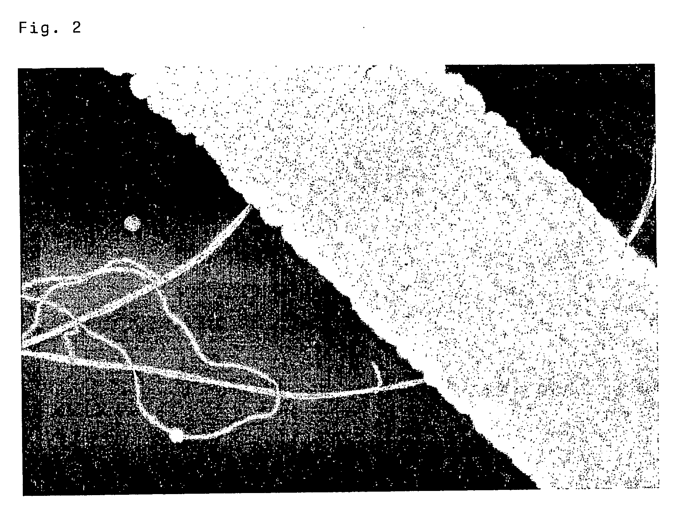

Die Figuren 1 und 2 zeigen rasterelektronenmikroskopische Aufnahmen eines Ausschnitts einer Mikroschaltung, in der Kohlenstoff-Nanoröhren mittels des erfindungsgemäßen Verfahrens kontaktiert worden sind.

Das erfindungsgemäße Verfahren ermöglicht ferner in besonders vorteilhafter Weise, daß sowohl einzelne Nanoröhren als auch Arrays von Nanoröhren in einem hochparallelen Verfahren auf vorbestimmten Leiterbahnanordnungen mechanisch fest kontaktiert werden. Die dabei erzeugten Kontaktstellen sind erheblich niederohmiger, als wenn die Nanoröhren lediglich über van der Waalsche Kräfte auf den Leiterbahnen gehalten werden bzw. abgelegt sind. Die im Rahmen des erfindungsgemäßen Verfahrens erzeugten Kontaktstellen weisen üblicherweise Kontaktwiderstände von 10 kΩ oder weniger auf.

Im Schritt (a) des erfindungsgemäßen Verfahrens wird zunächst eine vorbestimmte, mindestens zwei Leiterbahnen umfassende Leiterbahnanordnung auf ein Substrat aufgebracht. Üblicherweise kann dies durch ein herkömmliches "pattern-plating"-Verfahren erreicht werden. Dabei wird auf das Substrat eine Photolackschicht mit einer vorbestimmten Tiefenstruktur aufgebracht, d.h das Substrat wird mittels eines Photolacks mit einer geeigneten Vorstruktur bzw. einer vorbestimmten Struktur mit Vertiefungen (Tiefenstruktur), belegt. Verwendbare Substrate sind vorzugsweise Edelmetalle, oxidische Gläser, mono- oder multikristalline Substrate, Halbleiter, Metalle mit oder ohne passivierter Oberfläche, Isolatoren oder allgemein Substrate mit hoher Resistenz gegen die nachfolgenden Ätzprozeduren. Insbesondere handelt es sich hierbei um Pt, Au, GaAs, In_{Y}GaAs, AlₓGaAs, Si, SiO₂ Ge, SiₓN_{y}, SiₓGaAs, InP, InPSi, GaInAsP, Glas, Graphit, Diamant, Glimmer, SrTiO₃ sowie deren dotierte Modifikationen. Die verwendbaren Substrate können sowohl planare, ebene Substrate als auch solche mit planaren, gekrümmten (konvex oder konkav) Oberflächen sein. Als. Photolacke können die im Stand der Technik bekannten, im Handel erhältlichen Photolacke eingesetzt werden. Ein glattes Substrat, wie insbesondere Silizium mit einer darauf angeordneten SiO₂-Schicht, kann z.B. durch Spin-Coating mit einem Photolack beschichtet werden. Die Dicke des Films kann dabei zwischen 10 nm und mehreren µm betragen. Anschließend wird der Photolack in herkömmlicher Art und Weise durch eine Maske hindurch mit sichtbarem Licht, UV-Strahlung, Röntgenstrahlung oder Elektronenstrahlung in den gewünschten vorbestimmten Strukturen belichtet. Der Photolack wird anschließend entwickelt, d.h. es wird entweder der belichtete Teil aus dem Film herausgelöst (positiver Photolack) oder der unbelichtete Photolack wird aus dem Film herausgelöst (negativer Photolack). Die eingeschriebenen Muster und Strukturen stellen Vertiefungen in dem Photolack mit einer Tiefe dar, welche der Photolackschichtdicke entspricht. Hierbei können die Strukturen periodisch oder aperiodisch sein. Die Vertiefungen können beispielsweise eine Länge und eine Breite zwischen 15 nm und mehreren µm und eine Tiefe zwischen 5 nm und mehreren Mikrometern aufweisen. Insbesondere können vorbestimmte Strukturen gebildet werden, die größer als 40 nm sind. Eine vorbestimmte Struktur kann beispielsweise auch durch nur eine Wand des Photolackfilms, d.h. im Sinne einer Stufe, gebildet werden. Anschließend wird Metall auf das derart vorstrukturierte Substrat, beispielsweise mittels Sputtertechniken, Verdampfen oder "spin-on"-Techniken, aufgebracht. Das hierfür zu verwendende Metall unterliegt keiner spezifischen Beschränkung. So kann beispielsweise eine Goldschicht, insbesondere in Kombination mit einer Eisenschicht, aufgebracht werden. Dabei spielt es keine Rolle, ob das Eisen unter, über oder auch sandwichartig um die üblicherweise sehr dünn gestaltete Goldschicht (z.B. 5 bis 50 nm dick) angeordnet ist. Alternativ kann beispielsweise auch eine Au/Ti-Schichtanordnung vorgesehen werden, falls Eisen sich über der Goldschicht befindet. Abschließendes Entfernen der Photolackmaske mittels "lift-off"-Technik, z.B. Ätzen, führt zu der gewünschten Leiterbahnanordnung auf dem Substrat.

Im Schritt (b) des erfindungsgemäßen Verfahrens erfolgt das Aufbringen bzw. Ablegen von mindestens einer Nanoröhre auf dem in Schritt (a) strukturierten Substrat, d.h. der vorbestimmten Leiterbahnanordnung bzw. vorgesehenen Mikroschaltung.

Die im Schritt (b) verwendeten Nanoröhren können sowohl einwandig als auch mehrwandig gestaltet sein. Bei mehrwandigen Nanoröhren ist mindestens eine innere Nanoröhre von einer äußeren Nanoröhre koaxial umgeben. Vorzugsweise sind die in dem erfindungsgemäßen Verfahren verwendbaren Nanoröhren Kohlenstoff-Nanoröhren, mit Bornitrid dotierte Kohlenstoff-Nanoröhren oder oxidierte Kohlenstoff-Nanoröhren. Besonders bevorzugt sind Kohlenstoff-Nanoröhren.

Die Nanoröhren werden in Schritt (b) vorzugsweise mittels eines "Airbrush"-Verfahrens auf das in Schritt (a) erzeugte Substrat aufgebracht. Hierzu werden die Nanoröhren üblicherweise in einem polaren organischen Lösungsmittel dispergiert. Beispielhaft können hier Dimethylformamid, Acetonitril, Methylenchlorid, Chloroform, Methanol und Ethanol angeführt werden. Dimethylformamid ist besonders geeignet. Alternativ können die Nanoröhren auch in Wasser dispergiert werden. Die Konzentration der Nanoröhren in derartigen Dispersionen beträgt üblicherweise 1 bis 30 mg/l. In DMF beträgt die Konzentration beispielsweise ≤ 25 mg/l. Nach dem Aufbringen können die auf dem Substrat abgelegten Nanoröhren gegebenenfalls mit hochauflösenden Methoden wie der Kraftmikroskopie selektiert und/oder positioniert werden, so daß mindestens eine Nanoröhre in Kontakt mit zwei Leiterbahnen steht. Beispielsweise kann mindestens eine Nanoröhre zwei zueinander im wesentlichen parallel verlaufende Leiterbahnen verbrücken.

Im Schritt (c) des erfindungsgemäßen Verfahrens wird dann durch stromlose bzw. chemische Metallisierung ("electroless plating") mindestens ein Metall aus einem wässrigen Elektrolyten auf der bzw. den Leiterbahnen und damit gleichzeitig auch den Kontaktstellen Nanoröhre/Leiterbahn unter mindestens teilweisem Einschluss der Nanoröhren abgeschieden, so daß diese mit der Leiterbahn fest kontaktiert werden. Die Kontaktierung gelingt dabei selektiv und kann an Stellen errreicht werden, die durch herkömmliche PVD-Metallabscheidung nicht erreichbar sind. Zudem erfolgt die Metallisierung sehr schnell. In der Regel sind die Kontaktstellen und Leiterbahnen in weniger als einer Minute hinreichend beschichtet. Der feste Einschluss der Nanoröhre an den Kontaktstellen innerhalb der Leiterbahnanordnung gewährleistet deren mechanische Stabilität in der fertigen Schaltung bzw. dem elektronischen Bauteil.

Die in Schritt (c) des erfindungsgemäßen Verfahrens einsetzbaren Elektrolytzusammensetzungen sind prinzipiell aus der Technik der Oberflächenbehandlung, der Korrisionsbehandlung oder der Leiterplattenproduktion bekannt. So können im Rahmen des erfindungsgemäßen Verfahrens auf geeigneten Oberflächen Metalle wie insbesondere Nickel, Zinn, Kupfer, Kobalt, Platin, Palladium und Gold sowie deren Legierungen, vorzugsweise Nickel oder Kupfer, aus wässriger Lösung, d.h. aus deren Metallsalze, stromlos abgeschieden werden. Derartige Elektrolytzusammensetzungen sind im Stand der Technik bekannt und werden beispielsweise zu Korrosionsschutzzwecken bzw. zur Erzeugung von elektrischer Leitfähigkeit auf stark strukturierten, unebenen Oberflächen benutzt, für die eine Metallisierung im Vakuum aus Verfahrens- oder Kostengründen nicht in Frage kommt.

Besteht ein chemisches Potentialgefälle zwischem dem Metallsalz bzw. den Metallkationen des wässrigen, Metallkationen-enthaltenden Elektrolyten und dem Metall bzw. Legierung bzw. der aufgebrachten Leiterbahn, so wird das unedlere Metall der Leiterbahnanordnung oxidiert, während die Metallkationen des Elektrolyten reduziert werden und sich auf der Leiterbahnordnung niederschlagen. Die Struktur der abgeschiedenen Niederschläge ist meist feinkörnig. Sie enthalten in der Regel noch gewisse Elektrolytbestandteile oder deren Zwischenprodukte inkorporiert.

Die abgeschiedenen Niederschläge wirken auch katalytisch für die weitere Metallisierung. Besteht nämlich kein ausreichendes chemisches Potentialgefälle mehr, so wird die weitergehende Abscheidung im Rahmen des erfindungsgemäßen Verfahrens üblicherweise dadurch erreicht, daß für das "electroless plating" eine reduzierende Verbindung, wie beispielsweise Formaldehyd für Cu²⁺ bzw. Hypophosphit oder Boranat für Ni²⁺ oder Co²⁺, in die Elektrolytzusammensetzung gegeben wird.

Um beispielsweise im Rahmen der vorliegenden Erfindung die entsprechende Leiterbahnanordnung mit einer oder mehreren darauf abgeschiedenen Nanoröhren zu vernickeln, kann beispielsweise, wie im Stand der Technik bekannt, Nickel(II)chlorid mit Hypophosphit reduziert werden. Nickel schlägt sich dann auf der Leiterbahnanordnung unter Bedeckung der Nanoröhre/Leiterbahn-Kontaktstelle(n) nieder. Üblicherweise wird dabei der pH-Wert auf 8 bis 9 geregelt. Alternativ sind aber auch Metallisierungen im sauren Milieu bei einem pH-Wert im Bereich von 4 bis 6 möglich. Ist der pH-Wert zu alkalisch, würden ansonsten Nickelhydroxid bzw. basische Salze ausgefällt werden. Eine derartige Reaktion kann durch Zugabe von Komplexbildnern wie z.B. Citrat (oder Seignettesalz im Falle von Kupfer) vermieden werden, wodurch Nickel(II) komplexiert wird, so daß dessen Konzentration in der Elektrolytlösung verringert wird. Die im erfindungsgemäßen Verfahren einsetzbaren Bäder können üblicherweise die im Stand der Technik bekannten Badzusätze, wie Stabilisatoren, Aktivatoren bzw. Depolarisatoren, Leitsalze, Inhibitoren, Netzmittel, Glanzbildner, etc., enthalten.

Die erfindungsgemäß abgeschiedenen Niederschläge bzw. Schichten können gegebenenfalls noch galvanisch verstärkt werden.

Die Abscheidungsrate in Schritt (c) des erfindungsgemäßen Verfahrens beträgt üblicherweise 130 bis 300 nm/min. Die dabei abgeschiedenen Überzüge können beispielsweise eine Dicke im Bereich von 50 nm bis einige Mikrometer aufweisen.

Nach der stromlosen Metallisierung wird das derart behandelte Substrat in herkömmlicher Art und Weise gespült und getrocknet. Anschließend kann noch ein Temperschritt unter Vakuum oder Inertgasatmosphäre bei Anwendung von Temperaturen bis zu 1000°C in Abhängigkeit von dem metallischen Untergrund, beispielsweise für Nickel auf Gold im Bereich von 300 bis 500°C, durchgeführt werden, um eine im wesentlichen homogene Verschmelzung der abgeschiedenen Metallschicht zu bewirken. Vor einem solchen Temperschritt weist die abgeschiedene Metallschicht, welche die Leiterbahnen und die Nanoröhren an deren Kontaktstellen im wesentlichen vollständig mit Metall bedeckt, noch eine mehr oder minder feine Körnung auf.

Die vorliegende Erfindung wird durch das folgende Beispiel näher erläutert.

### Beispiel

Zunächst wird auf einem Siliziumsubstrat mit darauf angeordneter SiO₂-Schicht von einigen hundert Nanometern mittels Sputtertechnik unter Verwendung einer herkömmlichen Photolackmaske, die bereits mit den vorbestimmten Kontaktflächen bzw. Leiterbahnen vorstrukturiert ist, eine dünne (ungefähr 10 - 20 nm) Eisen- und Goldschicht aufgebracht. Alternativ wurde auch eine Titan-Gold-Schicht aufgebracht, über die anschließend noch eine 10 nm dicke Eisenschicht aufgesputtert wurde. Nach dem Lift-off-Schritt wurde auf der SiO₂-Oberfläche das entsprechend gewünschte, vorbestimmte Leiterbahnbild erhalten.

Anschließend wurde eine Dispersion von Kohlenstoff-Nanoröhren in Dimethylformamid/Isopropanol durch Sprühen auf das mit dem vorbestimmten Leiterbahnbild versehene Substrat aufgebracht ("Airbrush"-Verfahren).

Danach wurde das Substrat 15 Sekunden in eine 85°C warme ammoniakalische Metallisierungslösung getaucht, die bei einem pH-Wert von ungefähr 9 etwa 21 g Nickelchlorid, 24 g Natriumphosphinat, 40 g Trinatriumcitrat und 50 g Ammoniumchlorid pro Liter enthielt. Diese Metallisierungslösung wies einen pH-Wert von ungefähr 9 auf. Um eine reproduzierbare Reaktivität der Metallisierungslösung zu erhalten, wurde dabei vor dem Eintauchen des Substrats zunächst ein unbehandeltes Siliziumsubstrat in diese Metallisierungslösung eingetaucht, bis eine Gasentwicklung und eine Vernickelung deutlich festgestellt werden konnte. Nach der stromlosen Metallisierung wurde das Substrat mit Wasser und Isopropanol gespült und getrocknet.

Die hergestellten Proben wurden mit Rasterelektronenmikroskopie (REM) untersucht. Die Figuren 1 und 2 zeigen REM-Aufnahmen eines Ausschnitts einer Mikroschaltung, in der Kohlenstoff-Nanoröhren gemäß der vorliegenden Erfindung kontaktiert sind. Figur 1 zeigt, daß die Leiterbahnen und die Nanoröhren an den Kontaktstellen vollständig mit Nickel bedeckt sind. Die Nanoröhren sind auf den Oberflächen der Leiterbahnen unter der abgeschiedenen Nickelschicht "begraben". In Figur 1 ist die Nanoröhrenspur noch deutlich erkennbar. Figur 2 zeigt einen vergrößerten Ausschnitt der Figur 1. Die auf dem Substrat angeordneten Leiterbahnen sind noch nicht derart verbreitert, daß diese sich berühren. Die REM-Aufnahmen wurden dabei vor einem abschließenden Temperschritt gemacht. In dem nachfolgenden Temperschritt wird eine wesentlich homogenere Verschmelzung der abgeschiedenen Nickelschicht bewirkt. Zudem wird eine Absenkung der Kontaktwiderstände um den Faktor 2 bis 3 gegenüber den im ungetemperten Zustand gemessenen Werten erhalten.

Vor einem solchen Temperschritt weist die abgeschiedene Nickelschicht, welche die Leiterbahnen und die Nanoröhren an deren Kontaktstellen vollständig mit Nickel bedeckt, üblicherweise noch eine mehr oder minder feine Körnung auf.

## Patentansprüche

1. Verfahren zur Kontaktierung von Nanoröhren im Rahmen deren Integration in einer elektrischen Schaltung, umfassend die Schritte:
(a) Aufbringen einer vorbestimmten, mindestens zwei Leiterbahnen umfassenden Leiterbahnanordnung auf ein Substrat,
(b) Aufbringen von mindestens einer Nanoröhre auf das in Schritt (a) derart strukturierte Substrat und
(c) Unterwerfen der in Schritt (b) erhaltenen Anordnung einer stromlosen Metallisierung in einem Badverfahren unter Anwendung eines wässrigen, Metallkationen-enthaltenden Elektrolyten dergestalt, daß Metall auf der Leiterbahnanordnung unter mindestens teilweisem Einschluß der mindestens einen Nanoröhre an deren Kontaktstellen mit den Leiterbahnen abgeschieden wird.

2. Verfahren nach Anspruch 1, wobei die mindestens eine Nanoröhre aus Kohlenstoff-Nanoröhren, mit Bornitrid dotierten Kohlenstoff-Nanoröhren oder oxidierten Kohlenstoff-Nanoröhren ausgewählt ist.

3. Verfahren nach Anspruch 1 oder 2, worin in Schritt (a) das Aufbringen einer vorbestimmten, mindestens zwei Leiterbahnen umfassenden Leiterbahnanordnung auf ein Substrat mittels eines "pattern-plating"-Verfahrens erfolgt.

4. Verfahren nach einem der Ansprüche 1 bis 3, worin in Schritt (b) die Nanoröhren mittels eines "Airbrush"-Verfahrens aufgebracht werden.

5. Verfahren nach einem der Ansprüche 1 bis 4, worin nach dem Aufbringen in Schritt (b) die auf dem Substrat abgelegten Nanoröhren kraftmikroskopisch selektiert und/oder positioniert werden, so daß mindestens eine Nanoröhre in Kontakt mit zwei Leiterbahnen steht.

6. Verfahren nach einem der Ansprüche 1 bis 5, worin in dem Badverfahren gemäß Schritt (c) mindestens ein Metall, ausgewählt aus der Gruppe, bestehend aus Nickel, Zinn, Kupfer, Kobalt, Platin, Palladium und Gold aus wässriger Lösung stromlos abgeschieden wird oder dessen Legierungen, vorzugsweise Nickel-oder Kupferlegierungen, aus wässriger Lösung stromlos abgeschieden werden.

7. Verfahren nach Anspruch 6, wobei das Metall Nickel oder Kupfer ist.

8. Verfahren nach einem der Ansprüche 1 bis 7, worin nach Schritt (c) ein Temperschritt durchgeführt wird.

9. Verfahren nach einem der Ansprüche 1 bis 8, worin die Abscheidungsrate in Schritt (c) 130 bis 300 nm/min beträgt.

10. Verfahren nach einem der Ansprüche 1 bis 9, wobei das Substrat aus Pt, Au, GaAs, In_{Y}GaAs, AlₓGaAs, Si, SiO₂, Ge, SiₓN_{y}, SiₓGaAs, InP, InPSi, GaInAsP, Glas, Graphit, Diamant, Glimmer, SrTiO₃ sowie deren dotierten Modifikationen ausgewählt ist.

## Claims

1. Process for nanotube contact-making as part of their integration in an electric circuit, comprising the steps of:
(a) applying a predetermined interconnect arrangement which comprises at least two interconnects to a substrate,
(b) applying at least one nanotube to the substrate which has been patterned in this manner in step (a), and
(c) subjecting the arrangement obtained in step (b) to electroless plating in a bath process using an aqueous electrolyte which contains metal cations, in such a manner that metal is deposited on the interconnect arrangement so as to at least partially enclose the at least one nanotube at its locations of contact with the interconnects.

2. Process according to Claim 1, in which the at least one nanotube is selected from carbon nanotubes, carbon nanotubes doped with boron nitride or oxidized carbon nanotubes.

3. Process according to Claim 1 or 2, wherein in step (a) the application of a predetermined interconnect arrangement which comprises at least two interconnects to a substrate takes place by means of a pattern-plating process.

4. Process according to one of Claims 1 to 3, wherein in step (b) the nanotubes are applied by means of an airbrush process.

5. Process according to one of Claims 1 to 4, wherein, after the application in step (b), the nanotubes which have been deposited on the substrate are positioned and/or selected by force microscopy, so that at least one nanotube is in contact with two interconnects.

6. Process according to one of Claims 1 to 5, wherein, in the bath process described in step (c), at least one metal selected from the group consisting of nickel, tin, copper, cobalt, platinum, palladium and gold is deposited electrolessly from an aqueous solution or alloys thereof, preferably nickel or copper alloys, are deposited electrolessly from an aqueous solution.

7. Process according to Claim 6, in which the metal is nickel or copper.

8. Process according to one of Claims 1 to 7, wherein a conditioning step is carried out after step (c).

9. Process according to one of Claims 1 to 8, wherein the deposition rate in step (c) is 130 to 300 nm/min.

10. Process according to one of Claims 1 to 9, in which the substrate is selected from Pt, Au, GaAs, In_{y}GaAs, AlₓGaAs, Si, SiO₂, Ge, SiₓN_{y}, SiₓGaAs, InP, InPSi, GaInAsP, glass, graphite, diamond, mica, SrTiO₃ and doped modifications thereof.

## Revendications

1. Procédé de mise en contact de nanotubes dans le cadre de leur intégration à un circuit électrique, comprenant les étapes suivantes :
(a) on applique sur un substrat un aménagement de pistes conductrices prédéfini comprenant au moins deux pistes conductrices,
(b) on applique au moins un nanotube sur le substrat structuré à l'étape (a) et
(c) on soumet l'aménagement obtenu à l'étape (b) à une métallisation sans courant dans un procédé avec bain en utilisant un électrolyte aqueux contenant des cations métalliques de sorte qu'un métal se dépose sur l'aménagement de pistes conductrices avec inclusion au moins partielle des au moins un nanotube à leurs points de contact avec les pistes conductrices.

2. Procédé selon la revendication 1, dans lequel le au moins un nanotube est choisi parmi les nanotubes de carbone, les nanotubes de carbone dopés au nitrure de bore ou les nanotubes de carbone oxydés.

3. Procédé selon la revendication 1 ou 2, dans lequel, à l'étape (a), l'application d'un aménagement de pistes conductrices prédéfini, comprenant au moins deux pistes conductrices, sur un substrat se fait à l'aide d'un procédé de revêtement métallique sélectif.

4. Procédé selon l'une quelconque des revendications 1 à 3, dans lequel, à l'étape (b), on applique les nanotubes au moyen d'un procédé aérosol.

5. Procédé selon l'une quelconque des revendications 1 à 4, dans lequel, après l'application à l'étape (b), on sélectionne et/ou positionne les nanotubes déposés sur le substrat à l'aide d'un microscope puissant de sorte qu'au moins un nanotube soit en contact avec deux pistes conductrices.

6. Procédé selon l'une quelconque des revendications 1 à 5, dans lequel, dans le procédé avec bain selon l'étape (c), au moins un métal, choisi dans le groupe constitué du nickel, du cuivre, du cobalt, du platine, du palladium et de l'or, est déposé sans courant à partir d'une solution aqueuse ou dont les alliages, de préférence les alliages de nickel ou de cuivre, sont déposés sans courant à partir d'une solution aqueuse.

7. Procédé selon la revendication 6, dans lequel le métal est le nickel ou le cuivre.

8. Procédé selon l'une quelconque des revendications 1 à 7, dans lequel une étape de recuit est mise en oeuvre après l'étape (c).

9. Procédé selon l'une quelconque des revendications 1 à 8, dans lequel la vitesse de dépôt à l'étape (c) est de 130 à 300 nm/mn.

10. Procédé selon l'une quelconque des revendications 1 à 9, dans lequel le substrat est choisi parmi les substances suivantes : Pt, Au, GaAs, In_{y}GaAs, AlₓGaAs, Si, SiO₂, Ge, SiₓN_{y}, SiₓGaAs, InP, InPSi, GaInAsP, le verre, le graphite, le diamant, le mica, SrTiO₃ ainsi que leurs variantes dopées.
